(19) Europäisches Patentamt
European Patent Office
Office européen des brevets

(11) Publication number: **0 145 345**
**B1**

(12) **EUROPEAN PATENT SPECIFICATION**

(45) Date of publication of patent specification: **08.02.89**

(51) Int. Cl.$^4$: **G 03 C 1/68,** C 08 F 2/48

(21) Application number: **84307991.4**

(22) Date of filing: **19.11.84**

# (54) Solder masks.

(30) Priority: **06.12.83 GB 8332520**
**06.06.84 GB 8414438**

(43) Date of publication of application:
**19.06.85 Bulletin 85/25**

(45) Publication of the grant of the patent:
**08.02.89 Bulletin 89/06**

(84) Designated Contracting States:
**AT BE CH DE FR GB IT LI NL SE**

(56) References cited:
**EP-A-0 112 650**
**WO-A-81/02474**
**GB-A-2 086 926**
**US-A-3 914 194**
**US-A-4 308 338**
**US-A-4 369 288**

(73) Proprietor: **IMPERIAL CHEMICAL INDUSTRIES PLC**
**Imperial Chemical House Millbank**
**London SW1P 3JF (GB)**

(72) Inventor: **Lindley, Andrew Arthur**
**32 Bellemonte Road**
**Frodsham Warrington WA6 6BN (GB)**

(74) Representative: **Thomas, Ieuan et al**
**Imperial Chemical Industries PLC Legal Department: Patents PO Box 6 Bessemer Road**
**Welwyn Garden City Herts, AL7 1HD (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 145 345 B1

**Description**

This invention relates to compositions which comprise polymerisable material and photoinitiators for the polymerisation thereof, and particularly to such compositions for use in the preparation of solder masks.

During the construction of printed circuit boards, wires from a variety of devices, e.g. transistors, mounted on the board are fed through holes in the board and soldered therein to make contact with the circuit, e.g. of copper, on the printed circuit board. Soldering may be effected by, for example, dipping the board in a solder bath or wave soldering. It will be appreciated that during the soldering step the board has to be protected such that solder is deposited only on the appropriate portions of the board and does not inadvertently short-circuit the printed circuit.

We have now found that certain polymerisable compositions may be used in the preparation of so-called "solder masks" for printed circuit boards to protect them during a soldering step to which they may be subjected.

According to the present invention there is provided a polymerisable composition which comprises

(a) an additional polymerisable olefinically unsaturated oligomer which (i) comprises the repeating unit ($Ar^1$—$CHR^1$)
wherein $Ar^1$, each of which may be the same or different along the oligomer backbone, is an aromatic group, and

$R^1$, each of which may be the same or different along the oligomer backbone, is hydrogen or a hydrocarbyl group,
and (ii) has pendant and/or terminal acyloxymethyl groups in which the acyl group is derived from an olefinically unsaturated carboxylic acid;

(b) an addition polymerisable vinyl urethane;

(c) one or more polymeric binders; and

(d) a photo-initiator system.

By "aromatic/aldehyde oligomers" we mean oligomers which (i) comprise the repeating unit ($Ar^1$—$CHR^1$) wherein $Ar^1$, each of which may be the same or different along the oligomer backbone, is an aromatic group, or a suitably substituted derivatives thereof, and $R^1$, each of which may be the same or different along the oligomer backbone, is hydrogen or a hydrocarbyl group and (ii) have pendant and/or terminal acyloxymethyl groups in which the acyl group is derived from an olefinically unsaturated carboxylic acid.

The aromatic groups in an aromatic/aldehyde oligomer, where such an oligomer is used in the present invention, may be mono-nuclear, e.g. as in phenylene; fused polynuclear, e.g. as in naphthalene or anthracene; or preferably have the structure —Ø—$Y^1$—Ø—. In —Ø—$Y^1$—Ø—, Ø is the phenylene group and $Y^1$ is a direct link between the two phenylene groups; a divalent residue which contains one or more in-chain atoms, each of which atoms may be carbon or a hetero atom and may have one or more atoms appendant thereto, e.g. —O—, —S—, or —$CH_2$— or a substituted derivative of —$CH_2$—, e.g. —$C(CH_3)_2$—; —$CH_2CH_2$—; or

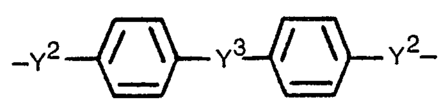

where $Y^2$, each of which may be the same or different, is a group which activates the aromatic nucleus to electrophilic attack, e.g. —O— and —S—, and $Y^3$ is a group which deactivates the aromatic nucleus to electrophilic attack, e.g. —$SO_2$— and —CO—.

Substituents which may be present on the aromatic groups include *inter alia* lower alkyl groups having up to five carbon atoms, e.g. methyl and ethyl; lower alkoxy groups e.g. methoxy; and halo groups, e.g. chloro.

$R^1$ in the repeating unit $-\!\!(Ar^1—CHR^1)\!\!-$ is preferably hydrogen. We do not exclude the possibility, however, that it may be an aryl group, e.g. phenyl; an alkaryl group, e.g. tolyl; an aralkyl group, e.g. benzyl; or an alkyl group having up to six carbon atoms.

Aromatic/aldehyde oligomers for use in the present invention preferably have functionalities between 2 and 6 and more preferably between 3 and 4. At functionalities less than 2 curing of the polymerisable composition is too slow; at functionalities more than 6 the cured product is often too brittle.

By "functionality" we mean the average number of pendant and terminal groups on each aromatic/aldehyde oligomer molecule.

In aromatic/aldehyde oligomers for use in the present invention in which the aromatic group $Ar^1$ has the structure —Ø—$Y^1$—Ø, it is preferred that the ratio of *para-para* linkages to *ortho-para* linkages is between 5:1 and 2:1.

By *"para-para* linkages" we mean a linkage in which —$CHR^1$— groups are attached to both phenylene groups in the residue —Ø—$Y^1$—Ø— at positions which are *para* to the linkage joining the —$Y^1$— residue to the phenylene groups.

By *"ortho-para* linkage" we mean a linkage in which a —$CHR^1$— group is attached to a first phenylene group in the residue —Ø—$Y^1$—Ø— at a position which is *ortho* to the position at which the —$Y^1$— residue is attached to the first phenylene group and a —$CHR^1$— group is attached to the second phenylene group in the residue —Ø—$Y^1$—Ø— at a position which is para to the position at which the —$Y^1$— residue is attached to the second phenylene group.

Aromatic/aldehyde oligomers for use in the present invention preferably have viscosities such that when they are mixed with polymeric binders as hereinafter defined and in the ratios as hereinafter described compositions are obtained which are tack-free and do not flow on storage at room temperature during their useful life.

Aromatic/aldehyde oligomers for use in the present invention preferably have number average molecular weights of between 900 and 1100 and weight average molecular weights of between 1900 and 2500.

Aromatic/aldehyde oligomers for use in the present invention may be prepared under the conditions which are more fully described in our copending European Patent Specification No. 0,112,650A.

As examples of vinyl urethanes which may be used in the present invention may be mentioned those described in United Kingdom Patent Specification Nos. 1,352,063, 1,465,897 and 1,498,421, and German Offenlegunschrift 2,419,887.

Preferably vinyl urethanes for use in the present invention are the reaction products of a urethane prepolymer and a hydroxyalkyl ester of acrylic or methacrylic acid, the urethane prepolymer being the reaction product of a di-isocyanate of the structure OCN—$R^2$—NCO, where $R^2$ is a divalent hydrocarbyl radical, preferably an alkylene radical having up to ten carbon atoms, e.g. hexamethylene, and a diol of the structure HO—$R^3$—OH, where $R^3$ is the residue of a condensate of an alkylene oxide with an organic compound containing two phenolic or alcoholic groups, which di-isocyanate and diol are preferably reacted in a molar ratio of 2:1.

Polymeric binders for use in the present invention are thermoplastics which on addition to solutions of the at least one polymerisable olefinically unsaturated oligomer in suitable solvents increase the viscosity of such solutions and tend to reduce the tackiness of solid layers deposited therefrom. They often have molecular weights of between 10,000 and 1,000,000 and preferably between 20,000 and 100,000.

It will be appreciated that polymeric binders for use in the present invention will have Tg's above 20°C, preferably between 50°C and 120°C, and more preferably about 90°C, good thermal stability and should not unduly adversely affect the rate of polymerisation of the polymerisable composition. Use of polymeric binders having Tg's of about 90°C often gives polymerisable compositions which flow to form better laminates in the production of three-layer elements as hereinafter described under conventional production conditions of temperature, about 100°C, and rate of throughput.

As examples of suitable polymeric binders may be mentioned *inter alia* polystyrene, polymethyl methacrylate, poly-vinyl acetate, polyvinyl butyral, 'Haloflex' (RTM), 'Alloprene' (RTM) and polyvinyl pyrrolidone. Preferred polymeric binders include polymethyl methacrylate or preferably copolymers of methyl methacrylate and lower alkyl having up to 6 carbon atoms, e.g. ethyl and butyl, methacrylates or preferably acrylates, typically in a molar ratio of about 9:1.

Polymeric binders typically provide between 10 and 30% w/w, and preferably between 15 and 20% w/w, of the polymerisable composition.

The amount of polymeric binder used in polymerisable compositions according to the present invention and the Tg thereof will be chosen in the light of the conditions under which a three-layer element is prepared from the polymerisable composition as hereinafter described. Use of too much polymeric binder may lead to a flaky layer of the polymerisable composition in the three-layer element.

Polymerisable compositions according to the present invention may contain one or more substances which bear one or more polymerisable olefinically unsaturated groups and which is (are) copolymerisable with the at least one polymerisable olefinically unsaturated oligomer. Such substances are hereinafter referred to for convenience as "comonomers".

As examples of comonomers which may be present in polymerisable compositions according to the present invention and which contain one polymerisable olefinically unsaturated group may be mentioned readily available monomers selected from the classes including *inter alia* hydrocarbons, e.g. styrene; ethers, e.g. vinyl ethyl ether; esters, e.g. vinyl acetate, methyl methacrylate, ethyl acrylate, butyl methacrylate and 2-ethylhexyl methacrylate; and amides, e.g. N-vinyl pyrrolidone, and N-alkyl acrylamides.

As examples of comonomers which may be present in polymerisable compositions according to the present invention and which contain a plurality of polymerisable olefinically unsaturated groups may be mentioned polymerisable prepolymers. As examples of such prepolymers may be mentioned the reaction products of a diol, particularly a bisphenol, with a glycidyl alkacrylate, for example those described in United States Patent Specification Nos. 3066112 and 4131729. The disclosures in the aforementioned specifications are incorporated herein by way of reference.

Preferably, however, comonomers, where present in polymerisable compositions according to the present invention, are low viscosity compounds containing a plurality of polymerisable olefinically unsaturated groups. As examples of such compounds may be mentioned (alk)acrylic acids esters of polyhydroxy compounds, for example, diethylene glycol, trimethylolpropane and pentaerythritol, e.g.

triethylene glycol dimethacrylate and trimethylolpropane trimethacrylate.

The photoinitiator system for use in the present invention may comprise any of the known photoinitiator systems which are used to initiate polymerisation of polymerisable olefinically unsaturated monomers. As examples of such systems can be mentioned *inter alia* (a) mixtures of Michler's ketone and benzil or preferably benzophenone, typically in a weight ratio of about 1:4; (d) mixtures of amines and ketones as disclosed in EP 90493A, e.g. camphorquinone or fluorenone and N,N-dimethylaminoethyl methacrylate, typically in a weight ratio of about 1:1, (c) the coumarin-based photoinitiator systems described in US 4,289,844, (d) combinations of hexaarylbisimidazoles and leuco dyes, (e) cyclohexadienone-leuco dye systems described in US 4341860, or preferably (f) systems based on dimethoxyphenyl-acetophenone (benzil dimethylketal) and/or diethoxyacetophenone.

The concentration of the photoinitiator system used in the polymerisable composition of the present invention is typically up to about 10% w/w.

We do not exclude the possibility that polymerisable compositions according to the present invention may contain a peroxy initiator, but this is not preferred.

To improve adhesion of the cured layer of polymerisable compositions according to the present invention to the metal, particularly copper, of the circuit on a printed circuit board in the preparation of a solder mask a suitable adhesion promoter is advantageously present in the polymerisable composition and, where the at least one polymerisable olefinically unsaturated oligomer consists of one or more vinyl urethanes, is often essential. Such adhesion promoters are known in the adhesives art, they often contain a group which is reactive with or has an affinity for the polymerisable composition and a group which interacts with the metal. As examples of suitable adhesion promotors may be mentioned *inter alia* polymerisable phosphate esters, silanes or preferably the heterocyclic compounds described in US 3,837,964, more preferably suitably substituted benzotriazoles.

Suitably substituted benzotriazoles which may be used in the present invention preferably bear an (alk)acrylate group which is attached to the benzene ring of the benzotriazole by a chain of between 5 and 12 atoms and preferably 8 or 9 atoms. As a preferred example of such benzotriazoles may be mentioned methacroyl-capramido-5-benzotriazole.

It is preferred that an adhesion promoter, where used, is soluble in the polymerisable composition and in any solvent which is used in the deposition of a substantially tack-free solid layer from the polymerisable composition.

Optionally polymerisable compositions according to the present invention on exposure to actinic radiation of a wavelength which is absorbed by the photoinitiator system interact therewith such that a colour contrast between exposed and unexposed regions of the polymerisable composition is generated. For example, where the polymerisable composition is colourless a colour may be generated in the exposed region thereof, or preferably, where the polymerisable composition is coloured the colour disappears or changes in the exposed region thereof. For the generation of such a contrast the polymerisable composition preferably contains a light sensitive system which absorbs the aforesaid actinic radiation. As examples of such light sensitive systems may be mentioned *inter alia* leuco dyes, e.g. crystal violet; fluoran and a compound which generates an acid on exposure to suitable actinic radiation, e.g $Ph_3S^+PF_6^-$; and a combination of a light fast dye, typically blue in colour, and a light unstable dye, typically yellow in colour.

Polymerisable compositions according to the present invention may contain a pigment, for example a phthalocyanine green.

Polymerisable compositions according to the present invention typically contain processing aids. As examples of processing aids may be mentioned *inter alia* surfactants, flow modifiers and anti-blocking agents. Suitable such agents are well known in the art and include *inter alia* $CF_3(CF_2CF_2)_{17}CH_2CH_2OCO(CH_2)_{16}CH_3$ or preferably a silicone acrylate or more preferably a silicone diacrylate.

Polymerisable compositions according to the present invention may contain a particulate filler, e.g. a silica. It will be appreciated that where a particulate filler is present it does not unduly adversely affect the properties of the polymerisable composition. However, the presence of a particulate filler is not preferred.

Polymerisable compositions according to the present invention typically contain a suitable thermal polymerisation inhibitor. As examples of such inhibitors may be mentioned *inter alia* p-methoxyphenol, hydroquinone, alkyl- and aryl- substituted hydroquinones and quinones, and t-butyl catechol. Such inhibitors are used in a concentration of up to a few weight % of the polymerisable composition.

It is often preferred that polymerisable compositions according to the present invention contain a flame retardant. Such flame retardants may be present as an additive, e.g. antimony oxide or a suitable phosphate ester, or may be an integral part of one of the at least one polymerisable olefinically unsaturated oligomers, e.g. a vinyl urethane may be derived from brominated bisphenol-A.

In a preferred embodiment of the present invention, the polymerisable composition comprises (a) 40—80% w/w of an aromatic/aldehyde oligomer, (b) up to 40% w/w of a vinyl urethane derived from oxypropylated bisphenol A, hexamethylene diisocyanate, and hydroxypropyl methacrylate, (c) 10—30% w/w of a polymethyl methacrylate homo- and/or copolymer, (d) a suitably substituted benzotriazole, (e) a photoinitiator system for initiating polymerisation of the polymerisable composition and (f) optionally various additives as hereinbefore described, the combined weight percentages of the components (a)-(f) amounting to 100%.

Conveniently polymerisable compositions according to the present invention are used in the form of a

three-layer element in which a layer of the polymerisable composition, preferably a solid tack-free layer thereof, is sandwiched between a support film and a cover film.

As examples of suitable polymers of which the support film may be comprised may be mentioned *inter alia* polyamides, polyolefins, vinyl polymers, cellulose or preferably polyesters, more preferably polyethylene terethphalate. Preferably the support film transmits actinic radiation of a wavelength which is to be used to cure the polymerisable composition. Preferably the support film has low permeability to oxygen. The thickness of the support film may be between 5 μm and 200 μm, and typically is between 10 and 50 μm.

Where the support film is a polyester it is preferred that the at least one polymerisable olefinically unsaturated oligomer comprises an aromatic/aldehyde oligomer since we have found that the presence of such an oligomer facilitates the release of the polyester support film from the cured polymerisable composition. We do not exclude the possibility that the solid layer may be in the form of a laminate in which a first lamella which is in contact with the polyester support film comprises an aromatic/aldehyde oligomer and a second lamella consists of or comprises a vinyl urethane.

The cover film may be made from a polymer which has hereinbefore been indicated as suitable for the preparation of the support film. Preferably the cover film comprises a polyolefin and more preferably polyethylene. The thickness of the cover film is between 5 microns and 200 μm and typically between 20 microns and 50 μm.

The polymerisable composition of the present invention is typically used in the form of a dry substantially tack-free layer of thickness between 20 and 150 μm and preferably between 30 and 100 μm. Where the thickness of the layer is less than about 40 μm the at least one polymerisable olefinically unsaturated oligomer may consist of one or more aromatic/aldehyde oligomers.

Preferably the polymerisable composition is applied to the support film in solution in a suitable solvent and the solvent evaporated off to leave a solid layer, although we do not exclude the possibility that the polymerisable composition may be heated, applied in a softened state to the support film and allowed to harden. The cover film is then laminated to the solid layer to provide a three-layer element.

As examples of suitable solvents from which the solid layer may be cast may be mentioned *inter alia* methylethyl ketone, methylene dichloride or 1,1,1-trichloroethane or mixtures thereof.

The solid layer of the polymerisable composition according to the present invention is flowable at elevated temperatures so as to be able to encapsulate the conductors of the printed circuit when used as a solder mask but has little or no flow at room temperature, about say 20°C, such that the layer sandwiched between the support film and the cover film can be rolled up into a tight roll of at least tens of layers for handling and storage.

In use, the cover film is removed from the three-layer element and the exposed surface of the solid layer of the polymerisable composition is brought into contact with a suitable printed circuit, the metallic portions of the surface of which typically are formed from copper and/or tin/lead alloy, and is laminated to one or both surfaces thereof, for example using a conventional vacuum laminator or resilient heated pressure rolls. It will be appreciated that the temperature and pressure are such that the layer of polymerisable composition is forced to conform to the contours of the printed circuit load to encapsulate the conductors without excessive thinning of the layer or puncture of it by the conductors to produce a solder mask. The laminate is exposed imagewise, preferably through the support film, to radiation having a wavelength in the range of 250 to 600 nanometres, preferably in the range of 320 nanometres to 500 nanometres, with the unexposed area of the layer corresponding to the area of the printed circuit where solder is to be applied. The support film is removed, for example by peeling off, and the solder mask is developed by washing away the unexposed areas of the solid layer with a suitable washing solvent to leave a printed circuit board one surface of which, except for the area(s) thereof to which solder is to be applied, is covered by a solder mask, which may be post-cured, for example by heating at a temperature in the range 120°C to 250°C, or by exposure to UV radiation, e.g. in conventional UV-curing equipment, or a combination thereof.

The aforesaid suitable washing solvent is conveniently 1,1,1-trichloroethane. However, we do not exclude the possibility that the washing solvent may be chosen in the light of the nature of the polymeric binder. For example, where polyvinyl butyral is present the washing solvent is typically methyl ethyl ketone; where polymethyl methacrylate is present the washing solvent is typically 1,1,1-trichloroethane; and where polyvinyl pyrrolidone is present the washing solvent is typically cyclohexanone.

Solder masks prepared from polymerisable compositions of the present invention often have dimensional stability at high humidity, e.g. a humidity of 92% at 90°C for 1 month; are resistant to attack by methylene chloride; can often withstand contact with the surface of molten solder at 285°C (a) for 30 seconds and (b) for 6 seconds, followed by 21 seconds in aid and a further 6 seconds contact, without any undue adverse change in appearance and essentially no reduction in adhesion; have good image resolution and fidelity.

Accordingly, a further aspect of the present invention provides a process for forming a solder mask on a surface bearing a conductive circuit which process comprises the steps of:

(a) applying to the surface which bears a conductive circuit a first surface of a layer, preferably a solid layer, of a polymerisable composition as defined in Claim 1 the second surface of the said layer having adhering thereto a support film, then in either order;

(b) exposing the layer, imagewise, to actinic radiation to form a polymeric image in the layer; and

(c) stripping the support film from the layer; then

(d) washing away the unexposed areas of the layer to leave a layer of polymeric material on the said surface except on the one or more portions of the said surface to which solder is to be applied; and

(e) post-curing the layer of polymeric material.

The present invention is further illustrated by reference to the following Examples.

Example 1

This example illustrates the preparation of an aromatic/aldehyde oligomer for use in the present invention.

Paraformaldehyde (25 kilograms) was added to sulphuric acid (specific gravity 1.550; 234.9 kilograms) with stirring in an atmosphere of 5% oxygen in nitrogen at room temperature and the mixture was heated to 65°C. Methacrylic acid (stabilised with 100 ppm hydroquinone and 100 ppm Topanol "O"; 117 litres) was added to the mixture followed, over a 30 minute period, by the addition of a solution of diphenyl ether (28 litres) in methacrylic acid (25 litres) while the reaction temperature was maintained at 64—67°C. The reaction mixture was stirred at 64—67°C for 3 hours and then allowed to stand for 15 minutes.

Phase separation occurred and the upper organic layer was recovered, sodium nitrite (100 ppm based on methacrylic acid) was added, and it was washed with water (150 litres × 2) at 60C. On standing it separated into a lower oligomeric phase and an upper methacrylic acid phase.

The oligomeric phase was cooled to about 30°C, was washed with 50% v/v aqueous methanol, and was dissolved in methylene chloride (80 litres). The solution was analysed for residual acid content and a 10% excess of 10% aqueous ammonium was slowly added to the solution. An emulsion formed which was broken by the addition of methanol (50 litres) and by standing overnight.

The lower layer from the broken emulsion was passed through a 5 A molecular sieve column. The methylene chloride was evaporated off to leave an aromatic/aldehyde oligomer (46 kilograms), $M_n = 972$; $M_w = 2144$; acid value, 13 mgs KOH/gram; saponification value 219 mgs KOH/gram; hydroxyl value, 31 mgs KOH/gram; functionality, 3.57; ratio of *para-para* linkages to *ortho-para* linkages = 4.3:1.

Example 2

This example illustrates the preparation of a vinyl urethane for use in the present invention.

Condensate (32.2 grams; 0.1 mole) obtained by reacting 2,2-bis-(4-hydroxyphenyl)-propane and propylene oxide in a molar ratio of 1:2 (oxypropylated bisphenol A) was dissolved in approximately 100 grams of methylene chloride and the resulting solution was added dropwise to a solution of hexamethylene diisocyanate 33.6 g (0.2 mole) in methylene chloride (100 g) under an atmosphere of nitrogen gas. 4 drops of dibutyl tin dilaurate (available as "Mellite" 12, "Mellite" is a registered trade mark) were added as catalyst. The mixture was stirred under nitrogen for 1 hour after which it was heated under reflux conditions for 9 hours. The mixture was then cooled and a solution of hydroxypropyl methacrylate 29 g (0.2 mole) in methylene chloride (100 g) was added after which the mixture was heated under reflux conditions for 3 hours. The hydroxypropyl ester comprised isomers in weight ratio 2-hydroxypropyl (2.6 parts) to 1-methyl-2-hydroxyethyl (1 part). The methylene chloride was evaporated off to leave a vinyl urethane.

Examples 3—10

Examples 7 and 8 illustrate the preparation of tack-free solid layers from polymerisable compositions according to the present invention.

General Procedure

A solution of polymerisable oligomer, polymeric binder, photoinitiator system and, where indicated, pigment, stabiliser, adhesion promoter and antiblocking agent in a suitable solvent was coated onto a Melinex (RTM) polyester support film. In Examples 3 and 4, the support film was 70 µm thick; in Examples 5 to 10, the support film was 23 µm thick. In Examples 3 and 4, a 100 µm wet film thickness coiled wire coating bar was used; in Examples 5 to 10, a 200 µm wet film thickness coiled wire coating bar was used. The wet film was dried using a hot air blower and was allowed to stand at room temperature for 2 hours (Examples 3 and 4) or 3 days (Examples 5 to 10). A tack-free solid layer approximately 40 µ thick (Example 3), 50 µm thick (Example 4) or 75 µm thick (Examples 5 to 10) was obtained which was essentially solvent-free.

In Examples 5—10, where a vinyl urethane was used in the preparation of the aforementioned solution it was used in the form of a 73 w/w % solution in methylene chloride; where an aromatic/aldehyde oligomer was used in the preparation of the aforementioned solution it was used in the form of a 70% w/w solution in 1,1,1-trichloroethane; and where a polymeric binder was used in the preparation of the aforementioned solution it was used in the form of a 40% w/w solution in methyl ethyl ketone. Where required, an appropriate amount of an appropriate solvent was added to obtain a coating solution of desired concentration.

The compositions of the coating solutions are given in Table 1 and the compositions (% w/w) of the substantially tack-free solid layers are given in Table 2.

In Examples 3 and 4, a three-layer element was prepared by laminating a polyethylene cover film to the bare surface of the solid layer using a hot-roll laminator at 60°C. The cover film could be removed readily from the solid layer.

TABLE 1

| Example No. | Concentration (% w/w) of Solvent in Coating Solution | | |
|---|---|---|---|
| | Methyl ethyl ketone | 1,1,1-Trichloro-ethane | Methylene Chloride |
| 3 | 45.0 | 0 | 0 |
| 4 | 45.0 | 0 | 0 |
| 5 | 26.3 | 0 | 16.0 |
| 6 | 26.3 | 0 | 16.0 |
| 7 | 25.9 | 9.2 | 8.0 |
| 8 | 25.9 | 9.2 | 8.0 |
| 9 | 25.7 | 18.1 | 0 |
| 10 | 25.7 | 18.1 | 0 |

TABLE 2

| Example No. | Oligomer | Polymeric binder | Co-Monomer | Adhesion Promoter | Initiator System | Stabi-liser | Pig-ment | Anti-blocking Agent |
|---|---|---|---|---|---|---|---|---|
| 3 | A (57.2) | F (38.1) | 0 | 0 | K (4.6) | N (0.05) | 0 | 0 |
| 4 | B (41.8) | G (33.0) | H (5.5) | I (12.1) | L (6.6) | N (1.0) | 0 | 0 |
| 5 | C (75.1) | F (18.8) | 0 | J (0.1) | M (5.6) | 0 | P (0.2) | Q (0.2) |
| 6 | C (75.2) | F (18.8) | 0 | 0 | M (5.6) | 0 | P (0.2) | Q (0.2) |
| 7 | E (75.1) | F (18.8) | 0 | J (0.1) | M (5.6) | 0 | P (0.2) | Q (0.2) |
| 8 | E (75.1) | F (18.8) | 0 | 0 | M (5.6) | 0 | P (0.2) | Q (0.2) |
| 9 | D (75.1) | F (18.8) | 0 | J (0.1) | M (5.6) | 0 | P (0.2) | Q (0.2) |
| 10 | D (75.2) | F (18.8) | 0 | 0 | M (5.6) | 0 | P (0.2) | Q (0.2) |

Symbols used in Table 2

A: An aromatic/aldehyde oligomer prepared from diphenyl oxide, paraformaldehyde and methacrylic acid and having a functionality of 3.25, an $M_n$ of 810, and an $M_w$ of 1200.

B: An aromatic/aldehyde oligomer prepared from diphenyl oxide, paraformaldehyde and methacrylic acid and having a functionality of 3.8 and an $M_n$ of 920.

C: The vinyl urethane prepared in Example 2.

D: The aromatic/aldehyde oligomer prepared in Example 1.

E: A mixture containing equal weights of C and D.

F: A copolymer of methyl methacrylate and butyl acrylate in weight ratio of 9:1, having a $M_n$ of 43200 and a $M_w$ of 65,000.

G: Polymethyl methacrylate of $M_n$ 25,000.

H: Triethylene glycol.

I: A mixture of J and a polymerisable phosphate ester prepared as described in US 3754972 in a weight ratio of 1:10.

J: Methacroyl-apramido-4-benzotriazole.

K: A mixture of 2-dimethylamino-ethyl benzoate and 4-benzoyl-4'-methyldiphenyl sulphide in a weight ratio of 1:1.

L: 2,2-Dimethoxy-2-phenylacetophenone.

M: A mixture of L and diethoxyacetophenone in a weight ratio of 1:1.

N: 2,6- D-t-butyl-4-methyl phenol.

P: A phthalocyanine green pigment (Monastral Grene LAG (RTM)).

Q: A silicone acrylate anti-blocking agent (Ebecryl 350 (RTM)).

Examples 11—24

Examples 15, 16, 21 and 22 illustrate the production of solder masks by the process of the present invention.

The bare surfaces of portions of the tack-free solid layers prepared in Examples 3—10 were contacted with the copper surface of a conventional copper-coated board used in the electronics industry, or to a circuitised tin/leaded 56.7 gm (2 oz) copper FR4 epoxy board (Examples 19—24). Both types of board were scrubbed with Scotchbrite (RTM) 3M, washed with water and dried with a hot air blower prior to use. The tack-free solid layer was laminated to the board under the following conditions: (A) in a hot platen press at 90°C and 276 kPa (40 psi) for 30 seconds (Example 11); or (B) in a Dynachem (RTM) Model 300 Laminator at 105°C at a throughput of 457 mm (1.5 feet) per minute followed by heating at 135°C for 1 hour (Example 12); or (C) in the laminator used in (B) at 100°C at a throughput of 914 mm (3 feet) per minute (Examples 13—18); or (D) under the conditions used in (C) and with the addition of 241 kPa (35 psi) compressed air pressure (Examples 19 to 24) to form a laminate which comprised a board, a tack-free layer and a Melinex (RTM) support film.

The laminates were allowed to cool for 30 minutes and were then exposed, through the Melinex (RTM) film, to UV radiation from a "Countess" exposure unit containing two MLU 300 w Philips UV lamps (ex Parker Graphics Ltd) for a defined period of time with a Stouffer 21-step sensitivity guide disposed on the Melinex (RTM) film. After exposure the products were allowed to stand for a defined period of time, the Melinex (RTM) film was removed and the layer was washed with 1,1,1-trichloroethane for 30 seconds. Steps up to and including the step wedge numbers indicated in Table 3 were resistant to the washing.

To prepare solder masks, Examples 11 to 24 were repeated (Example 11 was repeated twice) except that the Stouffer step wedge was not used, that after removal of the Melinex (RTM) film the washing step was omitted and the cured layer was post-cured by heating at 140°C for 1 hour (Example 11) or by exposure to UV radiation, from a Philips HPR 125 w Mercury Discharge Reprographic Lamp at a distance of 40 cm, for 24 hours (Examples 11 and 12) or by exposure as used in the curing step followed by heating at 160°C for 1 hour (Examples 13 to 24).

The resistance of the solder masks (Examples 12—24) to methylene chloride was determined by placing three drops of methylene chloride on first samples thereof and allowing to stand for one minute. The results are shown in Table 4.

The resistance of the solder masks (Examples 13—24) to a solder bath was determined as follows. Second samples of the solder masks were dipped in Multicore Rosin Foam Flux PC 26, placed solder mask surface down for 30 seconds on a 60:40 tin/lead solder bath at 285°C, allowed to cool for 30 seconds and the surface was washed with 1,1,1-trichloroethane for 1 minute. The second samples recovered from this treatment are hereinafter referred to as treated solder masks. The treated solder masks produced in Examples 13 to 18 were found to be neither dulled nor blistered; the treated solder masks produced in Examples 19 to 24 were found to be rippled. A 2 mm cross-hatch pattern was scored in the solder masks produced in Examples 13 to 18. Pieces of 3M Scotch (RTM) 610 tape were pressed firmly against the surfaces and against the treated solder masks produced in Examples 19 to 24. The pieces were removed with a sharp tug. In comparative tests, pieces of 3M Scotch (RTM) 610 tape were pressed firmly against third samples of the solder masks produced in Examples 13—24; the third samples from Examples 13 to 18 were provided with a 2 mm cross-hatch pattern prior to contact with the pieces of tape. Retention of the treated solder masks to the board is illustrated in Table 4. From Table 4 it can be seen that the adhesion of

the solder masks to the base-board after being subjected to treatment in a solder bath is at least 80% of that of the untreated solder masks.

TABLE 3

| Example No. | Solid Layer Prepared in Example No. | Exposure Time (minutes) | Standing Time (minutes) | Step Wedge No. | Ease of Melinex (RTM) Removal |
|---|---|---|---|---|---|
| 11 | 3 | 10 | 10 | 11 | A |
| 12 | 4 | 8 | 10 | 11 | A |
| 13 | 5 | 5 | 30 | 8 | B |
| 14 | 6 | 5 | 30 | 8 | B |
| 15 | 7 | 5 | 30 | 12 | A |
| 16 | 8 | 5 | 30 | 12 | A |
| 17 | 9 | 5 | 30 | 15 | C |
| 18 | 10 | 5 | 30 | 15 | C |
| 19 | 5 | 5 | 30 | 8 | B |
| 20 | 6 | 5 | 30 | 8 | B |
| 21 | 7 | 5 | 30 | 12 | A |
| 22 | 8 | 5 | 30 | 12 | A |
| 23 | 9 | 5 | 30 | 15 | C |
| 24 | 10 | 5 | 30 | 15 | C |

A: Melinex (RTM) removed cleanly in one piece.
B: Very difficult with some tearing of the Melinex (RTM).
C: Melinex (RTM) removed easily in one piece.

TABLE 4

| Example No. | $CH_2Cl_2$ resistance | % Solder mask retained |
|---|---|---|
| 12 | A | a |
| 13 | A | 90 |
| CT13 | | 98 |
| 14 | A | 2 |
| CT14 | | 5 |
| 15 | B | 85 |
| CT15 | | 95 |
| 16 | B | 85 |
| CT16 | | 95 |
| 17 | C | 50 |
| CT17 | | 50 |
| 18 | C | 20 |
| CT18 | | 20 |
| 19 | A | 80 |
| CT19 | | 100 |
| 20 | A | 80 |
| CT20 | | 100 |
| 21 | B | 80 |
| CT21 | | 100 |
| 22 | B | 80 |
| CT22 | | 100 |
| 23 | C | 80 |
| CT23 | | 100 |
| 24 | C | 80 |
| CT24 | | 100 |

a: Not determined.
A: No blistering.
B: Surface remains shiny.
C: Surface remains shiny and unchanged.
CT: Comparative test.

**Claims**

1. A polymerisable composition which comprises

(a) an addition polymerisable olefinically unsaturated oligomer which (i) comprises the repeating unit

$-(Ar^1-CHR^1)-$

wherein $Ar^1$, each of which may be the same or different along the oligomer backbone, is an aromatic group, or a suitably substituted derivative thereof, and

$R^1$, each of which may be the same or different along the oligomer backbone, is hydrogen or a

hydrocarbyl group,
and (ii) has pendant and/or terminal acyloxymethyl groups in which the acyl group is derived from an olefinically unsaturated carboxylic acid;

(b) an addition polymerisable vinyl urethane;

(c) one or more polymeric binders; and

(d) a photo-initiator system.

2. A polymerisable composition as claimed in claim 1 wherein the aromatic groups $Ar^1$ in the oligomer have the structure —Ø—$Y^1$—Ø— wherein Ø is the phenylene group and Y is a direct link between two phenylene groups, or a divalent residue which contains one or more in-chain atoms each of which atoms may be carbon or a hetero atom and may have one or more atoms appendant thereto.

3. A polymerisable composition as claimed in claim 2 wherein $Y^1$ is oxygen.

4. A polymerisable composition as claimed in claim 2 wherein the aldehyde from which the oligomer is derived is formaldehyde.

5. A polymerisable composition as claimed in claim 1 wherein the oligomer has on average between 2 and 6 acyloxymethyl groups per oligomer molecule.

6. A polymerisable composition as claimed in claim 1 wherein the oligomer has a number average molecular weight of between 900 and 1100 and a weight average molecular weight of between 1700 and 2500.

7. A polymerisable composition as claimed in claim 1 wherein the vinyl urethane is the reaction product of a urethane prepolymer and a hydroxyalkyl ester of acrylic or methacylic acid, the said urethane prepolymer being the reaction product of a diisocyanate of formula OCN—$R^2$—NCO, where R2 is a divalent hydrocarbyl radical, and a diol of formula HO—$R^3$—OH where $R^3$ is the residue of a condensate of an alkylene oxide with an organic compound containing two phenolic or alcoholic groups.

8. A polymerisable composition as claimed in claim 1 wherein the one or more polymeric binders is a homo- or co-polymer of methyl methacrylate.

9. A polymerisable composition as claimed in claim 1 wherein the photo-initiator system is based on dimethoxyphenyl-acetophenone and/or diethyoxyacetophenone.

10. A polymerisable composition as claimed in claim 1 comprising a suitable substituted benzotriazole.

11. A polymerisable composition as claimed in claim 1 comprising (a) 40—80% w/w of an oligomer, (b) up to 40% w/w of a vinyl urethane, (c) 10—30% of a methyl methacrylate homo- or co-polymer, (d) a benzotriazole which is substituted with a group which is reactive with or has an affinity for the polymerisable composition, (e) a photo-initiator system and (f) optionally various additives as hereinbefore described, and wherein the combined percentage weights of components (a)-(f) total 100%.

12. A three-layer element comprising a polymerisable composition as claimed in claim 1 sandwiched between a support film and a cover film.

13. A process for the preparation of a three-layer element as claimed in claim 12 which process comprises applying the polymerisable composition according to claim 1 to the support film to form a substantially tack-free solid layer on one surface thereof and then laminating the cover film to the substantially tack-free solid layer.

14. A process for the preparation of a solder mask on a surface bearing a conductive circuit which process comprises the steps of (a) applying to a surface which bears a conductive circuit a first surface of a layer, preferably a solid layer, of a polymerisable composition as claimed in Claim 1, the second surface of the said layer having adhering thereto a support film, then in either order; (b) exposing the layer, imagewise, to actinic radiation to form a polymeric image in the layer; and (c) stripping the support film from the resulting image-bearing layer; (d) washing away the unexposed areas of the layer to leave a layer of polymeric material on the said surface except on the one or more portions of the said surface to which solder is to be applied; and (e) post-curing the layer of polymeric material.

**Patentansprüche**

1. Polymerisierbare Zusammensetzung, dadurch gekennzeichnet, daß sie

(a) ein durch Polyaddition polymerisierbares olefinisch ungesättigtes Oligomer, das (i) die Struktureinheit $-(Ar^1—CHR^1)-$ enthält, worin

$Ar^1$, wovon jedes entlang der Oligomer-Hauptkette gleich oder verschieden sein kann, eine aromatische Gruppe ist und $R^1$, wovon jedes entlang der Oligomer-Hauptkette gleich oder verschieden sein kann, ein Wasserstoffatom oder eine Kohlenwasserstoffgruppe ist,
und (ii) seitenständige und/oder endständige Acyloxymethylgruppen hat, in denen die Acylgruppe abgeleitet ist von einer olefinisch ungesättigten Carbonsäure;

(b) ein durch Polyaddition polymerisierbares Vinylurethan;

(c) ein oder mehr als ein polymeres Bindemittel und

(d) ein Fotoinitiatorsystem enthält.

2. Polymerisierbare Zusammensetzung nach Anspruch 1, dadurch gekennzeichnet, daß die aromatischen Gruppen $Ar^1$ in dem Oligomer die Struktur —Ø—$Y^1$—Ø— besitzen, worin Ø die Phenylengruppe und Y eine direkte Bindung zwischen zwei Phenylengruppen oder ein zweiwertiger Rest ist, der ein oder mehr als ein innenkettiges Atom enthält, wobei jedes von diesen Atomen ein Kohlenstoff-oder ein Heteroatom sein kann und ein oder mehr als ein daranhängendes Atom besitzen kann.

3. Polymerisierbare Zusammensetzung nach Anspruch 2, dadurch gekennzeichnet, daß $Y^1$ Sauerstoff ist.

4. Polymerisierbare Zusammensetzung nach Anspruch 2, dadurch gekennzeichnet, daß der Aldehyd, von dem das Oligomer abgeleitet ist, Formaldehyd ist.

5. Polymerisierbare Zusammensetzung nach Anspruch 1, dadurch gekennzeichnet, daß das Oligomer durchschnittlich zwischen 2 und 6 Acyloxymethylgruppen pro Oligomermolekül besitzt.

6. Polymerisierbare Zusammensetzung nach Anspruch 1, dadurch gekennzeichnet, daß das Oligomer ein Durchschnittsmolekulargewicht (Zahlenmittel) zwischen 900 und 1100 und ein Durchschnittsmolekulargewicht (Massemittel) zwischen 1700 und 2500 besitzt.

7. Polymerisierbare Zusammensetzung nach Anspruch 1, dadurch gekennzeichnet, daß das Vinylurethan das Reaktionsprodukt eines Urethanvorpolymers und eines Hydroxyalkylesters von Acryl- oder Methacrylsäure ist, wobei das genannte Urethanvorpolymer das Reaktionsprodukt eines Diisocyanats der Formel $OCN—R^2—NCO$, worin $R^2$ ein Zweiwertiger Kohlenwasserstoffrest ist, und eines Diols der Formel $HO—R^3—OH$ ist, worin $R^3$ der Rest eines Kondensates eines Alkylenoxids mit einer organischen Verbindung, die 2 phenolische oder alkoholische Gruppen enthält, ist.

8. Polymerisierbare Zusammensetzung nach Anspruch 1, dadurch gekennzeichnet, daß das eine oder mehr als eine polymere Bindemittel ein Homo- oder Copolymer von Methylmethacrylat ist.

9. Polymerisierbare Zusammensetzung nach Anspruch 1, dadurch gekennzeichnet, daß das Fotoinitiatorsystem auf Dimethoxyphenylacetophenon und/oder Diethoxyacetophenon basiert.

10. Zusammensetzung nach Anspruch 1, dadurch gekennzeichnet, daß sie ein geeignetes substituiertes Benzotriazol enthält.

11. Polymerisierbare Zusammensetzung nach Anspruch 1, dadurch gekennzeichnet, daß sie

(a) 40—80 Masse-% eines Oligomers,

(b) bis zu 40 Masse-% eines Vinylurethans,

(c) 10—30 Masse-% eines Methylmethacrylat-Homo- oder Copolymers,

(d) ein Benzotriazol, das mit einer Gruppe substituiert ist, die mit der polymerisierbaren Zusammensetzung reaktionsfähig ist oder zu dieser eine Affinität und

(e) ein Fotoinitiatorsystem und

(f) wahlweise verschiedene Additive wie vorstehend beschrieben, wobei sich die Prozentsätze der Komponenten (a) bis (f) zu insgesamt 100% addieren, enthält.

12. Dreischichtiges Bauteil, dadurch gekennzeichnet, daß es eine polymerisierbare Zusammensetzung nach Anspruch 1 enthält, die schichtweise zwischen einer Trägerfolie und einer Deckfolie angeordnet ist.

13. Verfahren für die Hestellung eines dreischichtigen Bauteils nach Anspruch 12, dadurch gekennzeichnet, daß es das Aufbringen der polymerisierbaren Zusammensetzung nach Anspruch 1 auf die Trägerfolie zur Bildung einer im wesentlichen nicht klebenden festen Schicht auf einer Oberfläche derselben und die nachfolgende Laminierung der Deckfolie auf die im wesentlichen nicht klebende feste Schicht umfaßt.

14. Verfahren zur Herstellung einer Lötmaske auf einer Oberfläche, die einen leitenden Schaltkreis trägt, dadurch gekennzeichnet, daß das Verfahren die Stufen

(a) Aufbringen einer ersten Oberfläche einer Schicht, vorzugsweise einer festen Schicht, einer polymerisierbaren Zusammensetzung nach Anspruch 1 auf eine Oberfläche, die einen leitenden Schaltkreis trägt, wobei die zweite Oberfläche der genannten Schicht eine an ihr haftende Trägerfolie besitzt, dann in irgendeiner Reihenfolge:

(b) bildweises Belichten der Schicht mit einer aktinischen Strahlung, um ein polymeres Bild in der Schicht zu erzeugen; und

(c) Abziehen der Trägerfolie von der resultierenden, bildtragenden Schicht;

(d) Wegwaschen der unbelichteten Flächen der Schicht, um eine Schicht des polymeren Materials auf der genannten Oberfläche, ausgenommen auf dem einen ode mehr als einen Teil der genannten Oberfläche, auf den Lötmittel aufgebracht werden soll, zurückzulassen und

(e) Nachhärten der Schicht des polymeren Materials umfaßt.

**Revendications**

1. Composition polymérisable, qui comprend

(a) un oligomère à non-saturation oléfinique polymérisable par addition qui (i) comporte le motif répeté $-\!\!\left(Ar^1—CHR^1\right)\!\!-$ dans lequel les groupes $Ar^1$, qui peuvent être identiques ou différents le long du squelette oligomérique, représentent chacun un groupe aromatique ou un dérivé convenablement substitué de ce groupe, et

les groupes $R^1$, qui peuvent être identiques ou différents le long du squelette oligomérique, représentent chacun un atome d'hydrogène ou un groupe hydrocarbyle,

et (ii) porte des groupes acyloxyméthyle latéraux et/ou terminaux dont le groupe acyle est dérivé d'un acide carboxylique à non-saturation oléfinique;

(b) un vinyluréthanne polymérisable par addition;

(c) un ou plusieurs liants polymériques; et

(d) un système photo-initiateur.

2. Composition polymérisable suivant la revendication 1, dans laquelle les groupes $Ar^1$ aromatiques de l'oligomère ont la structure —Ø—$Y^1$—Ø— dans laquelle Ø est le groupe phénylène et Y est une liaison directe entre deux groupes phénylène, ou un résidu divalent qui contient un ou plusieurs atomes en chaîne dont chacun peut être un atome de carbone ou un hétéro-atome et peut porter, attachés, un ou plusieurs atomes.

3. Composition polymérisable suivant la revendication 2, dans laquelle $Y^1$ est l'oxygène.

4. Composition polymérisable suivant la revendication 2, dans laquelle l'aldéhyde duquel l'oligomère est dérivé est le formaldéhyde.

5. Composition polymérisable suivant la revendication 1, dans laquelle l'oligomère a en moyenne entre 2 et 6 groupes acyloxyméthyle par molécule d'oligomère.

6. Composition polymérisable suivant la revendication 1, dans laquelle o'oligomère a une moyenne en nombre du poids moléculaire comprise entre 900 et 1100 et une moyenne en poids du poids moléculaire comprise entre 1700 et 2500.

7. Composition polymérisable suivant la revendication 1, dans laquelle le vinyluréthanne est le produit de réaction d'un prépolymère d'uréthanne et d'un hydroxyalkyl-ester d'acide acrylique ou méthacrylique, ledit prépolymère d'uréthanne étant le produit de réaction d'un diisocyanate de formule OCN—$R^2$—NCO, dans laquelle $R^2$ est un radical hydrocarbyle divalent, et d'un diol de formule HO—$R^3$—OH dans laquelle $R^3$ est le résidu d'un produit de condensation d'un oxyde d'alkylène avec un composé organizue contenant deux ou plus de deux groupes phénoliques ou alcooliques.

8. Composition polymérisable suivant la revendication 1, dans laquelle le ou les liants polymériques consistent en un homopolymère ou en un compolymère de méthacrylate de méthyle.

9. Composition polymérisable suivant la revendication 1, dans laquelle le système photo-initiateur est basé sur la diméthoxyphényl-acétophénone et/ou la diéthoxyacétophénone.

10. Composition polymérisable suivant la revendication 1, comprenant un benzotriazole substitué convenable.

11. Composition polymérisable suivant la revendication 1, comprenant (a) 40 à 80% en poids d'un oligomère, (b) jusqu'à 40% en poids d'un vinyluréthanne, (c) 10 à 30% en poids d'un homo-polymère d'un copolymère de méthacrylate de méthyle, (d) un benzotriazole qui est substitué avec un groupe qui est réactif avec, ou qui a une affinité pour, la composition polymérisable, (e) un système photo-initiateur et (f) à titre facultatif, divers additifs tels que décrits ci-dessus, et le total des pourcentages en poids des composants (a) à (f) est égal à 100%.

12. Eléments à trois couches comprenant une composition polymérisable suivant la revendication 1 intercalée entre un film de support et un film de revêtement.

13. Procédé de préparation d'un élément à trois couches suivant la revendication 12, procédé qui consiste à appliquer la composition polymérisable suivant la revendication 1 à un film de support pour former une couche solide principalement non collante sur l'une de ses faces, puis à stratifier le film de revêtement sur la couche solide principalement non collante.

14. Procédé de préparation d'un masque de soudage sur une surface portant un circuit conducteur, procédé qui comprend les étapes consistant (a) à appliquer à une surface qui porte un circuit conducteur une première surface formée d'une couche, de préférence une couche solide, d'une composition polymérisable suivant la revendication 1, la sconde surface de ladite couche portant un film de support adhérent, puis, dans l'ordre, (b) à exposer la couche, pour la formation de l'image, à des radiations actiniques de manière à former une image polymérique dans la couche; et (c) à détacher le film de support de la couche résultante portant l'image; (d) à éliminer par lavage les zones non exposées de la couche pour laisser une couche de matière polymérique sur ladite surface excepté sur la portion ou les portions de la surface où la soudure doit être appliquée; et (e) à effectuer la post-maturation de la couche de matière polymérique.